# EUROPEAN PATENT APPLICATION

(11) **EP 4 753 389 A2**
(43) Date of publication of application: **03.06.2026**
(21) Application number: 25219376.8
(22) Date of filing: 28.11.2025
(51) Int. Cl.: H05K 7/20

(54) **R718 ENHANCED IMMERSION COOLING SYSTEM**

(30) Priority: 30.11.2024 US 202463726484 P; 22.11.2025 US 202519397872
(71) Applicant: Vertiv International GmbH, 8212 Neuhausen am Rheinfall (CH)
(72) Inventor: BISSARO, Carlo, 8212 Schaffhausen (CH); BARBATO, Pierpaolo, 8212 Schaffhausen (CH); PARISE, Andrea, 8212 Schaffhausen (CH)
(74) Representative: Ambroz, Simon

(57) **Abstract**

An immersion cooling system can include an immersion tank for containing a refrigerant in both liquid and vapor phases, a heat exchanger for extracting heat from the refrigerant, and a pump for circulating the refrigerant from the tank to the heat exchanger and back to the tank. The tank can contain one or more electronic devices submerged in the liquid phase of the refrigerant, below a surface of the refrigerant in the tank. The pump can draw the refrigerant from the tank below the surface and/or return the refrigerant to the tank above the surface. The system can include an enclosure housing the tank, the heat exchanger, and the pump. The refrigerant can have a high specific heat and/or be non-toxic and/or non-flammable, such as water or a water-based refrigerant.

## Description

### CROSS-REFERENCE TO RELATED APPLICATION(S)

This application claims the benefit of U.S. Provisional Patent Application No. 63/726,484 filed November 30, 2024; and U.S. Nonprovisional Application No. 19/397,872 filed 22 November 2025.

### TECHNICAL FIELD

The present disclosure relates generally to immersion cooling systems, such as those used in data centers or other high density computing environments, and more specifically relates to two-phase immersion cooling systems.

### BACKGROUND

Two-phase immersion cooling systems are usually based on a tank containing a dielectric engineered fluid like 3M Novec 649. Electronics components, such as rack servers, are immersed in a bath of the fluid. Electronics components release heat directly in the liquid bath causing evaporation of the liquid. Vapor bubbles travel through the liquid towards the upper part of the tank enclosure, which is then occupied by the engineered fluid in gaseous phase. Here, typically, a bundle of tubes cooled by a separate chilled water facility is used to condense the engineered fluid from the gaseous phase, returning to the liquid bath in the form of condensed droplets. Limitations of such an arrangement can include a fixed boiling temperature of the liquid bath at atmospheric pressure tied to thermodynamic properties of the fluid, limited specific heat of the available engineered fluids, difficulties with vapor phase containment and safety/health issues when the tank is opened (such as for maintenance), a relatively long dripping time of electronics components when extracted from the bath, difficulties in handling hardware that has become slippery when wetted with the engineered fluid, high costs of the engineered fluids (especially considering the need to re-fill the tank after maintenance due to evaporation), an oily condensate in white space of a data center due to vapor and liquid being dispersed in the room during maintenance, as well as other issues.

### SUMMARY

Applicant has created new and useful devices, systems and methods for two-phase immersion cooling systems. In at least one example, an immersion cooling system according to the disclosure can efficiently use a safe/non-toxic refrigerant, such as water or R718, having a high specific heat for both cooling capacity production and cooling distribution over electronics that are immersed in the liquid bath. In at least one example, efficiency of the system can be increased by using jet impingement of the refrigerant upon the heat sources, such as electronic devices. In at least one example, by operating at sub-atmospheric pressures, the escape of refrigerant from the tank via outward leakage can be avoided or eliminated, even when the tank is opened, i.e., due to condensation of vaporized refrigerant as sub-atmospheric pressures within the tank rise to atmospheric pressure. In at least one example, any refrigerant escaping the tank, either in vapor or liquid form, is non-toxic, non-flammable, and can be easily and inexpensively replaced.

In at least one example, an immersion cooling system according to the disclosure can include an immersion tank for containing a refrigerant in both liquid and vapor phases and providing a bath to cool one or more electronic devices at least partially submerged therein. In at least one example, the system can include one or more compressors within the tank for compressing the refrigerant. In at least one example, the system can include one or more valves that allow the compressor to be operated in compression mode, wherein the compressor can draw in the refrigerant, as saturated water vapor released from the bath, and can discharge the refrigerant, as superheated water vapor at a higher pressure, to a condenser within the tank. In at least one example, the valves can bypass the compressor and allow the system to operate in free cooling mode.

In at least one example, an immersion cooling system according to the disclosure can include a heat exchanger for extracting heat from the refrigerant and/or a pump for circulating the refrigerant from the tank to the heat exchanger and back to the condenser within the tank. In at least one example, the pump can draw the refrigerant from the tank below the surface and/or return the refrigerant to the tank above the surface. In at least one example, the pump can draw the refrigerant from the condenser within the tank below the surface and/or return the refrigerant to the condenser within the tank above the surface. In at least one example, the system can include an enclosure housing the tank, the heat exchanger, the pump, or any combination thereof.

In at least one example, the refrigerant can have a high specific heat and/or be non-toxic and/or non-flammable, such as a water-based refrigerant. In at least one example, the refrigerant can be water, purified water, demineralized water, distilled water, or any combination thereof. In at least one example, the refrigerant can comport with an American Society of Heating, Refrigerating and Air-Conditioning Engineers (ASHRAE) standard 34 for R718 refrigerant.

In at least one example, the heat exchanger can be disposed outside of the tank. In at least one example, the heat exchanger can be a fluid-to-fluid heat exchanger, such as a brazed plate heat exchanger. In at least one example, the heat exchanger can transfer heat from the refrigerant to a cooling fluid. In at least one example, the same refrigerant used in the tank to extract heat from the electronic devices can be used to transport the heat to the heat exchanger external to the tank.

In at least one example, any or all of the cooling fluid can be circulated through an external heat exchanger disposed outside of a building housing the system. In at least one example, the external heat exchanger can reject any or all of the heat extracted from the electronic devices into the environment outside the building. In at least one example, any or all of the cooling fluid can be circulated through a heat recovery device inside of a building that houses the system. In at least one example, the heat recovery device can reject any or all of the heat extracted from the electronic devices into the building, such as for utilizing recovered heat to heat a portion of the building.

In at least one example, the system can direct or accelerate the refrigerant towards the electronic devices, below the surface, to more effectively extract heat from the electronic devices. In at least one example, the system can direct or accelerate the refrigerant towards the electronic devices using one or more pumps, one or more manifolds, one or more conduits, one or more nozzles, or any combination thereof, disposed in the tank and/or submerged in the tank below the surface of a body of liquid refrigerant.

In at least one example, the system can include a vacuum sub-system for selectively maintaining the tank at below the ambient pressure. In at least one example, the vacuum sub-system can include a condenser for condensing the refrigerant and/or a vacuum pump, such as for drawing a vacuum within the system before charging the system with refrigerant and/or extracting incondensable gasses. In at least one example, if water vapor is inadvertently collected by the vacuum pump, it can be condensed by the condenser. In at least one example, the vacuum sub-system can be at least partially disposed within the enclosure.

In at least one example, the system can include a water deionizing sub-system for minimizing conductivity of the refrigerant. In at least one example, the system can include a filtration sub-system for minimizing impurities within the refrigerant. In at least one example, the filtration sub-system can include one or more media filters and/or one or more ultraviolet lights. In at least one example, the water deionizing sub-system and/or the filtration sub-system can be at least partially disposed within the enclosure.

In at least one example, a controller can control the various valves, pumps, compressors, and other aspects of the system. In at least one example, the controller can control the valves and the compressor to operate the system in compression mode or in free cooling mode. In at least one example, the controller can control the pump to optimize the transfer of heat from the tank to the heat exchanger. In at least one example, the controller can control one or more additional valves to control the flow of the cooling fluid through the external heat exchanger and/or the heat recovery device to control the flow of the heat extracted from the electronic devices, such as according to a control signal from a building management system. In at least one example, the controller can control the pumps and/or nozzles that direct the refrigerant towards the electronic devices. In at least one example, the controller can control the vacuum sub-system and/or the water deionizing sub-system.

### BRIEF DESCRIPTION OF THE DRAWINGS

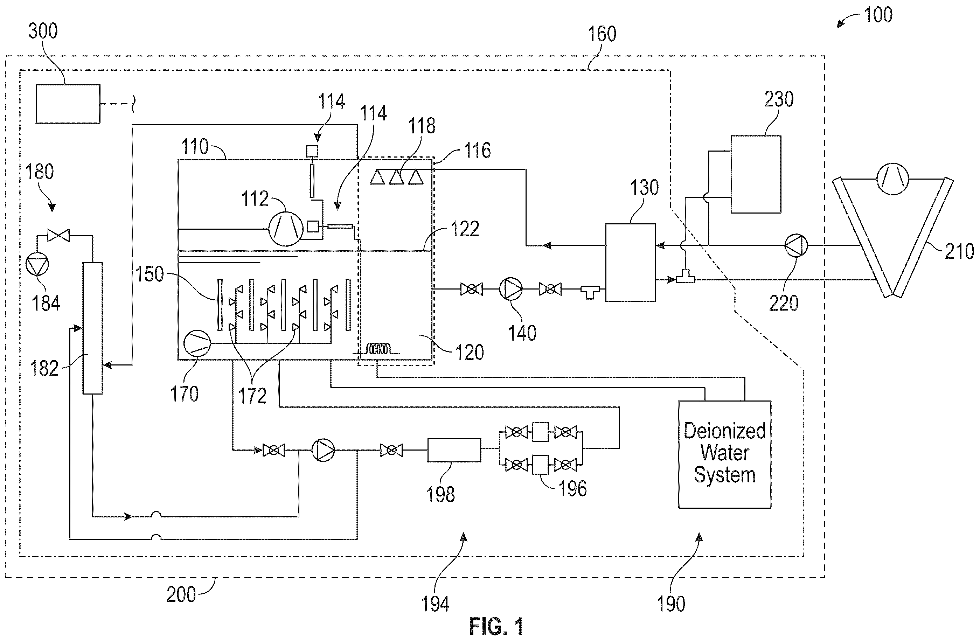

FIG. 1 is a schematic diagram of one of many examples of a two-phase immersion cooling system according to the disclosure.

### DETAILED DESCRIPTION

The figures described above and the written description of specific structures and functions below are not presented to limit the scope of what Applicant has invented or the scope of the appended claims. Rather, the figures and written description are provided to teach any person skilled in the art to make and use the inventions for which patent protection is sought. Those skilled in the art will appreciate that not all features of a commercial example of the inventions are described or shown for the sake of clarity and understanding. Persons of skill in this art will also appreciate that the development of an actual commercial example incorporating aspects of the present inventions will require numerous implementation-specific decisions to achieve the developer's ultimate goal for the commercial example. Such implementation-specific decisions may include, and likely are not limited to, compliance with system-related, business-related, government-related and other constraints, which may vary by specific implementation, location and from time to time. While a developer's efforts might be complex and time-consuming in an absolute sense, such efforts would be, nevertheless, a routine undertaking for those of skill in this art having benefit of this disclosure. It must be understood that the inventions disclosed and taught herein are susceptible to numerous and various modifications and alternative forms.

The use of a singular term, such as, but not limited to, "a," is not intended as limiting of the number of items. Also, the use of relational terms, such as, but not limited to, "top," "bottom," "left," "right," "upper," "lower," "down," "up," "side," and the like are used in the written description for clarity in specific reference to the figures and are not intended to limit the scope of the inventions or the appended claims. The terms "including" and "such as" are illustrative and not limitative. The terms "couple," "coupled," "coupling," "coupler," and like terms are used broadly herein and can include any method or device for securing, binding, bonding, fastening, attaching, joining, inserting therein, forming thereon or therein, communicating, or otherwise associating, for example, mechanically, magnetically, electrically, chemically, operably, directly or indirectly with intermediate elements, one or more pieces of members together and can further include without limitation integrally forming one functional member with another in a unity fashion. The coupling can occur in any direction, including rotationally. Further, all parts and components of the disclosure that are capable of being physically embodied inherently include imaginary and real characteristics regardless of whether such characteristics are expressly described herein, including but not limited to characteristics such as axes, ends, inner and outer surfaces, interior spaces, tops, bottoms, sides, boundaries, dimensions (e.g., height, length, width, thickness), mass, weight, volume and density, among others.

Any process flowcharts discussed herein illustrate the operation of possible implementations of systems, methods, and computer program products according to various examples of the present disclosure. In this regard, each block in a flowchart may represent a module, segment, or portion of code, which can comprise one or more executable instructions for implementing the specified logical function(s). It should also be noted that, in some implementations, the function(s) noted in the block(s) might occur out of the order depicted in the figures. For example, blocks shown in succession may, in fact, be executed substantially concurrently. It will also be noted that each block of a flowchart illustration can be implemented by special purpose hardware-based systems that perform the specified functions or acts, or combinations of special purpose hardware and computer instructions.

Applicant has created new and useful devices, systems and methods for two-phase immersion cooling systems. In at least one example, an immersion cooling system according to the disclosure can efficiently use a safe/non-toxic refrigerant, such as water or R718, having a high specific heat for both cooling capacity production and cooling distribution over electronics that are immersed in the liquid bath. In at least one example, efficiency of the system can be increased by using jet impingement of the refrigerant upon the heat sources, such as electronic devices. In at least one example, by operating at sub-atmospheric pressures, the escape of refrigerant from the tank via outward leakage can be avoided or eliminated, even when the tank is opened, i.e., due to condensation of vaporized refrigerant as sub-atmospheric pressures within the tank rise to atmospheric pressure. In at least one example, any refrigerant escaping the tank, either in vapor or liquid form, is non-toxic, non-flammable, and can be easily and inexpensively replaced.

FIG. 1 is a schematic diagram of one of many examples of a two-phase immersion cooling system according to the disclosure.

In at least one example, an immersion cooling system 100 according to the disclosure can include an immersion tank 110 for containing a refrigerant 120 in both liquid and vapor phases and providing a bath to cool one or more electronic devices 150 at least partially submerged therein. In at least one example, the electronic devices 150 can heat the bath of the refrigerant 120, and can cause portions of the refrigerant 120 to evaporate or vaporize, depending on the heat load presented by the electronic devices 150. In at least one example, the system 100 can include one or more compressors 112 within the tank 110 for compressing the refrigerant 120 in vapor phase. In at least one example, the system 100 can include one or more valves 114 that allow the compressor 112 to be operated in compression mode, wherein the compressor 112 can draw in the refrigerant 120, as saturated water vapor released from the bath due to heat from the electronic devices 150, and can discharge the refrigerant 120, as superheated water vapor at a higher pressure, to a condenser 116 within the tank 110, such as to provide increased cooling to the electronic devices 150 in the bath of the refrigerant 120. In at least one example, the valves 114 can bypass the compressor 112 and allow the system 100 to operate in free cooling mode, such as when the heat load from the electronic devices 150 is relatively low.

In at least one example, an immersion cooling system 100 according to the disclosure can include a heat exchanger 130 for extracting heat from the refrigerant 120 and/or a pump 140 for circulating the refrigerant 120 from the tank 110 to the heat exchanger 130 and back to the condenser 116, which can be a direct contact condenser, within the tank 110. In at least one example, the pump 140 can draw the refrigerant from the tank 110 below a surface 122 (or liquid surface) of the refrigerant 120 in the tank 110 and/or return the refrigerant 120 to the tank 110 above the surface 122. In at least one example, the pump 140 can draw the refrigerant 120 from the condenser 116 within the tank 110 below the surface 122 and/or return the refrigerant 120 to the condenser 116 within the tank 110 above the surface 122. In at least one example, the pump 140 can return the refrigerant 120 to spray nozzles 118 of the condenser 116 in the tank 110. In at least one example, the system can include an enclosure housing the tank, the heat exchanger, the pump, or any combination thereof.

In at least one example, the system can utilize the compressor 112 to regulate a temperature of the bath, and can selectively operate in compression mode or free cooling mode as needed to extract the variable heat from electronic devices 150. In at least one example, an operating pressure of the compressor 112 can be below an ambient pressure outside of the tank 110. In at least one example, the compressor 112 can output the refrigerant 120 at below an ambient pressure outside of the tank 110. In at least one example, the compressor 112 can be or include one or more high efficiency centrifugal compressors and/or can be arranged in single or multiple compression stages. In at least one example, multiple stages can be or include an intercooled dual stage solution and/or can utilize one or more ejectors or ejector modules. In at least one example, multiple compressors 112 can be arranged in a parallel layout to distribute high cooling capacity.

In at least one example, the refrigerant 120 can have a high specific heat and/or be non-toxic and/or non-flammable, such as by way of being a water-based refrigerant. In at least one example, the refrigerant 120 can be water, purified water, demineralized water, distilled water, or any combination thereof. In at least one example, the refrigerant 120 can comport with an American Society of Heating, Refrigerating and Air-Conditioning Engineers (ASHRAE) standard 34 for R718 refrigerant, i.e., can be R718. In at least one example, the same refrigerant 120 can be circulated through the bath in the tank 110 to extract heat from the electronic devices 150 and through the heat exchanger 130 to reject the extracted heat.

In at least one example, by using water in or as the refrigerant 120, the system 100 can avoid problems with leak exposures, refilling costs, difficult handling of immersed components, toxic vapors, or any combination thereof. In at least one example, by using water in or as the refrigerant 120, the system 100 can ensure efficient and high-performance heat transfer from the electronic devices 150 to the heat exchanger 130 for rejection outside of the system 100 or tank 110.

In at least one example, the heat exchanger 130 can be disposed outside of the tank 110. In at least one example, the heat exchanger 130 can be a fluid-to-fluid heat exchanger, such as a brazed plate heat exchanger (BPHE). In at least one example, the heat exchanger 130 can transfer heat from the refrigerant 120 to a cooling fluid, such as a water/glycol mixture, for rejection elsewhere via the cooling fluid. In at least one example, the same refrigerant 120 used in the tank 110 to extract heat from the electronic devices 150 can be used to transport the heat to the heat exchanger 130 external to the tank 110.

In at least one example, the system 100 can be housed inside of a building 200. In at least one example, any or all of the cooling fluid can be circulated through an external heat exchanger 210, such as a dry cooler and/or a condenser, disposed outside of a building 200 housing the system 100, such as by a cooling pump 220. In at least one example, the external heat exchanger 210 can reject any or all of the heat extracted from the electronic devices 150 into the environment outside the building 200.

In at least one example, any or all of the cooling fluid can be circulated through a heat recovery system or device 230, such as a fluid-to-air heat exchanger, inside of a building 200 housing the system 100. In at least one example, the heat recovery system or device 230 can reject any or all of the heat extracted from the electronic devices into the building 200, such as outside of the system 100 or tank 110. In at least one example, by using two-phase immersion, the system 100 can provide high evaporation temperatures, such as in the refrigerant 120 and/or the cooling fluid, for use with high temperature heat pumps, such as can be used in the heat recovery system or device 230.

In at least one example, the system 100 can direct or accelerate the refrigerant 120 towards the electronic devices 150, below the surface 122, to more effectively extract heat from the electronic devices 150 and/or increase heat transfer from the electronic devices 150. In at least one example, the system 100 can direct or accelerate the refrigerant 120 towards the electronic devices 150 using one or more pumps 170, one or more manifolds, one or more conduits, one or more nozzles 172, or any combination thereof, any or all of which can be disposed in the tank 110 and/or submerged below the surface 122.

In at least one example, the system 100 can include a vacuum sub-system 180 for selectively maintaining an interior of the tank 110 and/or any related plumbing or other components at a pressure below the ambient pressure surrounding the tank 110. In at least one example, the vacuum sub-system 180 can include a condenser 182 for condensing the refrigerant 120 and/or a vacuum pump 184, such as for drawing a vacuum within the system 100 before charging the system with refrigerant and/or extracting incondensable gasses. In at least one example, the vacuum sub-system 180 can be at least partially disposed within the enclosure 160. In at least one example, the condenser 182 and/or the vacuum pump 184 can be at least partially disposed within the enclosure 160. In at least one example, the vacuum sub-system 180 can extract incondensable air and/or contaminants that leak into the tank 110, such as due to the tank 110 operating at sub-ambient and/or sub-atmospheric pressure. In at least one example, if water vapor is inadvertently collected by the vacuum pump 184, it can be condensed by the condenser 182.

In at least one example, the system 100 can include a water deionizing sub-system 190 for minimizing conductivity of the refrigerant 120. In at least one example, the system 100 can include a water deionizing sub-system 190 for minimizing conductivity of the refrigerant 120, such as below a threshold. In at least one example, the system 100 can include a filtration sub-system 194 for minimizing minimize impurities, such as bacteria, bio-scaling, or other contaminants, within the refrigerant 120. In at least one example, the filtration sub-system 194 can maintain impurities, within the refrigerant 120, below a threshold. In at least one example, the filtration sub-system 194 can include one or more media filters 196 and/or one or more ultraviolet (UV) lights 198 for treating the refrigerant 120. In at least one example, the water deionizing sub-system 190 and/or the filtration sub-system 194 can be at least partially disposed within the enclosure 196. In at least one example, the media filter 196 and/or the ultraviolet light 198 can be at least partially disposed within the enclosure 160.

In at least one example, one or more controllers 300 can control the various valves, pumps, compressors, and other aspects of the system 100. In at least one example, the controller 300 can control the valves 114 and the compressor 112 to selectively operate the system 100 in compression mode and/or free cooling mode. In at least one example, the controller 300 can control the pump 140 to optimize the transfer of heat from the tank 110, such as from the cooling bath within the tank 110, to the heat exchanger 130. In at least one example, the controller 300 can control one or more additional valves 220 to control the flow of the cooling fluid through the external heat exchanger 210 and/or the heat recovery device 230 to control the flow of the heat extracted from the electronic devices 150, such as according to a control signal from a building management system. In at least one example, the controller 300 can control the pumps 170 and/or nozzles 172 for providing jet impingement of the refrigerant 120 towards the electronic devices 150. In at least one example, the controller 300 can control the vacuum sub-system 180 and/or the water deionizing sub-system 190.

In at least one example, the system 100 can allow access to the tank 110 and automatically contain the refrigerant 120, preventing loss of the refrigerant 120. In at least one example, when the tank 110 and/or other component(s) of the system 100 is opened, such as for maintenance, repair, or replacement, the tank 110 and/or other component(s) of the system 100 can experience a pressure increase, such as from sub-atmospheric pressure to atmospheric pressure. In at least one example, this increase in pressure can advantageously cause condensation of the refrigerant 120, which can assist in containing the refrigerant 120 and avoiding vapor dispersion upon opening the tank 110. In at least one example, at least because the refrigerant 120 is water or water-based, refilling the refrigerant 120 is safe, easy, and inexpensive. In at least one example, at least because the refrigerant 120 is water or water-based, handling the electronic devices 150 that have been submerged in the refrigerant 120 is safe and does not require special personal protective equipment. In at least one example, at least because the refrigerant 120 is water or water-based, any increase in humidity can be managed by the building management system.

As will be appreciated by those skilled in the art having the benefits of the present disclosure, aspects of one or more examples of the disclosure can be embodied as a system, method or computer program product. Accordingly, aspects of the present examples can take the form of an entirely hardware example, an entirely software example (including firmware, resident software, micro-code, etc.) or an example combining software and hardware aspects that may all generally be referred to herein as a "circuit," "module" or "system." Furthermore, aspects of the present disclosure may take the form of a computer program product embodied in one or more non-transitory computer readable mediums having computer readable program code embodied thereon. Any combination of one or more computer readable media may be utilized. The computer readable media may be a computer readable signal medium or a computer readable storage medium. A computer readable storage medium may be, for example, but not limited to, an electronic, magnetic, optical, electromagnetic, infrared, or semiconductor system, apparatus, or device, or any suitable combination of the foregoing. More specific examples of such computer readable storage media include but are not limited to the following: an electrical connection having one or more wires, a portable computer diskette, a hard disk, a random access memory (RAM), a read-only memory (ROM), an erasable programmable read-only memory (EPROM or Flash memory), an optical fiber, a portable compact disc read-only memory (CD-ROM), an optical storage device, a magnetic storage device, or any suitable combination of the foregoing. In the context of this document, a computer readable storage medium may be any tangible medium that can contain or store a program for use by or in connection with an instruction execution system, apparatus, or device.

Program code embodied on a computer readable medium may be transmitted using any appropriate medium or media, including but not limited to wireless, wireline, optical fiber cable, radio frequency (RF), or any suitable combination of the foregoing. Computer program code for carrying out operations for aspects of the present disclosure may be written in any combination of one or more programming languages, including an object oriented programming language such as Java, Smalltalk, C++ or the like and conventional procedural programming languages, such as the "C" programming language or similar programming languages. The program code may execute entirely on a user's computer, partly on a user's computer, as a stand-alone software package, partly on a user's computer and partly on a remote computer, or entirely on a remote computer or server. In the latter scenario, the remote computer may be connected to a user's computer through any type of network, including a local area network (LAN) or a wide area network (WAN), or the connection may be made to an external computer (for example, through the Internet using an Internet Service Provider or via a short-range wireless interconnection such as Bluetooth).

Aspects of the present disclosure can be described with reference to flowchart illustrations and/or block diagrams of methods, apparatuses (devices and systems) and computer program products according to examples of the disclosure. Each block of a flowchart illustration and/or block diagram, and combinations of blocks in a flowchart illustration and/or block diagrams, can be implemented by computer program instructions. These computer program instructions may be provided to a processor of a general purpose computer, special purpose computer, or other programmable data processing apparatus to produce a machine, such that the instructions, which executed via one or more processors, create means for implementing the functions/acts specified in the flowchart and/or block diagram block or blocks. The computer program instructions can be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks. The computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in a flowchart and/or block diagram block or blocks. Each block in a flowchart and/or block diagram can be split into multiple blocks and/or combined with other blocks to make a single block.

In at least one example, an immersion cooling system according to the disclosure can include an immersion tank for containing a refrigerant in both liquid and vapor phases and providing a bath to cool one or more electronic devices at least partially submerged therein. In at least one example, the system can include one or more compressors within the tank for compressing the refrigerant. In at least one example, the system can include one or more valves that allow the compressor to be operated in compression mode, wherein the compressor can draw in the refrigerant, as saturated water vapor released from the bath, and can discharge the refrigerant, as superheated water vapor at a higher pressure, to a condenser within the tank. In at least one example, the valves can bypass the compressor and allow the system to operate in free cooling mode.

In at least one example, an immersion cooling system according to the disclosure can include a heat exchanger for extracting heat from the refrigerant and/or a pump for circulating the refrigerant from the tank to the heat exchanger and back to the condenser within the tank. In at least one example, the pump can draw the refrigerant from the tank below the surface and/or return the refrigerant to the tank above the surface. In at least one example, the pump can draw the refrigerant from the condenser within the tank below the surface and/or return the refrigerant to the condenser within the tank above the surface. In at least one example, the system can include an enclosure housing the tank, the heat exchanger, the pump, or any combination thereof.

In at least one example, the refrigerant can have a high specific heat and/or be non-toxic and/or non-flammable, such as a water-based refrigerant. In at least one example, the refrigerant can be water, purified water, demineralized water, distilled water, or any combination thereof. In at least one example, the refrigerant can comport with an American Society of Heating, Refrigerating and Air-Conditioning Engineers (ASHRAE) standard 34 for R718 refrigerant.

In at least one example, the heat exchanger can be disposed outside of the tank. In at least one example, the heat exchanger can be a fluid-to-fluid heat exchanger, such as a brazed plate heat exchanger. In at least one example, the heat exchanger can transfer heat from the refrigerant to a cooling fluid. In at least one example, the same refrigerant used in the tank to extract heat from the electronic devices can be used to transport the heat to the heat exchanger external to the tank.

In at least one example, any or all of the cooling fluid can be circulated through an external heat exchanger disposed outside of a building housing the system. In at least one example, the external heat exchanger can reject any or all of the heat extracted from the electronic devices into the environment outside the building. In at least one example, any or all of the cooling fluid can be circulated through a heat recovery device inside of a building that houses the system. In at least one example, the heat recovery device can reject any or all of the heat extracted from the electronic devices into the building, such as for utilizing recovered heat to heat a portion of the building.

In at least one example, the system can direct or accelerate the refrigerant towards the electronic devices, below the surface, to more effectively extract heat from the electronic devices. In at least one example, the system can direct or accelerate the refrigerant towards the electronic devices using one or more pumps, one or more manifolds, one or more conduits, one or more nozzles, or any combination thereof, disposed in the tank and/or submerged in the tank below the surface of a body of liquid refrigerant.

In at least one example, the system can include a vacuum sub-system for selectively maintaining the tank at below the ambient pressure. In at least one example, the vacuum sub-system can include a condenser for condensing the refrigerant and/or a vacuum pump, such as for drawing a vacuum within the system before charging the system with refrigerant and/or extracting incondensable gasses. In at least one example, if water vapor is inadvertently collected by the vacuum pump, it can be condensed by the condenser. In at least one example, the vacuum sub-system can be at least partially disposed within the enclosure.

In at least one example, the system can include a water deionizing sub-system for minimizing conductivity of the refrigerant. In at least one example, the system can include a filtration sub-system for minimizing impurities within the refrigerant. In at least one example, the filtration sub-system can include one or more media filters and/or one or more ultraviolet lights. In at least one example, the water deionizing sub-system and/or the filtration sub-system can be at least partially disposed within the enclosure.

In at least one example, a controller can control the various valves, pumps, compressors, and other aspects of the system. In at least one example, the controller can control the valves and the compressor to selectively operate the system in compression mode or free cooling mode. In at least one example, the controller can control the pump to optimize the transfer of heat from the tank to the heat exchanger. In at least one example, the controller can control one or more additional valves to control the flow of the cooling fluid through the external heat exchanger and/or the heat recovery device to control the flow of the heat extracted from the electronic devices, such as according to a control signal from a building management system. In at least one example, the controller can control the pumps and/or nozzles that direct the refrigerant towards the electronic devices. In at least one example, the controller can control the vacuum sub-system and/or the water deionizing sub-system.

For example, the devices, systems and methods can be implemented for numerous different types and sizes in numerous different industries. Further, the various methods and examples of the devices, systems and methods can be included in combination with each other to produce variations of the disclosed methods and examples. Discussion of singular elements can include plural elements and vice versa. The order of steps can occur in a variety of sequences unless otherwise specifically limited. The various steps described herein can be combined with other steps, interlineated with the stated steps, and/or split into multiple steps. Similarly, elements have been described functionally and can be embodied as separate components or can be combined into components having multiple functions.

The inventions have been described in the context of preferred and other examples and not every example of the inventions has been described. Obvious modifications and alterations to the described examples are available to those of ordinary skill in the art having the benefits of the present disclosure. The disclosed and undisclosed examples are not intended to limit or restrict the scope or applicability of the inventions conceived of by the Applicant, but rather, in conformity with the patent laws, Applicant intends to fully protect all such modifications and improvements that come within the scope or range of equivalents of the following claims.

Described herein are also the following clauses:
1. An immersion cooling system comprising: an immersion tank configured to contain a refrigerant in both liquid and vapor phases, wherein the tank is configured to contain one or more electronic devices submerged in the liquid phase of the refrigerant below a surface of the refrigerant in the tank; a heat exchanger configured to extract heat from the refrigerant; and a pump configured to circulate the refrigerant from the tank to the heat exchanger and back to the tank.
2. The immersion cooling system as set forth in clause 1, wherein the pump is configured to draw the refrigerant from the tank below the surface and return the refrigerant to the tank above the surface.
3. The immersion cooling system as set forth in clause 1, wherein the refrigerant is water-based.
4. The immersion cooling system as set forth in clause 1, wherein the refrigerant is water.
5. The immersion cooling system as set forth in clause 1, wherein the refrigerant comports with an American Society of Heating, Refrigerating and Air-Conditioning Engineers (ASHRAE) standard 34 for R718 refrigerant.
6. The immersion cooling system as set forth in clause 1, wherein the heat exchanger is a brazed plate heat exchanger.
7. The immersion cooling system as set forth in clause 1, wherein the heat exchanger is configured to transfer heat from the refrigerant to a cooling fluid.
8. The immersion cooling system as set forth in clause 7, further comprising an external heat exchanger disposed outside of a building housing the system, wherein the external heat exchanger is configured to reject at least a portion of the heat extracted from the one or more electronic devices into an environment outside of the building.
9. The immersion cooling system as set forth in clause 7, further comprising a heat recovery device disposed inside of a building housing the system, wherein the heat recovery device is configured to reject at least a portion of the heat extracted from the one or more electronic devices into a portion of the building.
10. The immersion cooling system as set forth in clause 1, further comprising a pump submerged in the tank below the surface and configured to accelerate the refrigerant towards the one or more electronic devices.
11. The immersion cooling system as set forth in clause 1, further comprising a compressor disposed within the tank above the surface and configured to compress at least a portion of the refrigerant.
12. The immersion cooling system as set forth in clause 11, wherein the compressor is configured to draw in the refrigerant as saturated water vapor and to discharge the refrigerant, as water vapor at a higher pressure, to a condenser within the tank.
13. The immersion cooling system as set forth in clause 12, further comprising a water deionizing sub-system configured to minimize conductivity of the refrigerant.
14. The immersion cooling system as set forth in clause 13, wherein the water deionizing sub-system is at least partially disposed within the enclosure.
15. The immersion cooling system as set forth in clause 12, further comprising a filtration sub-system configured to minimize impurities within the refrigerant.
16. The immersion cooling system as set forth in clause 15, wherein the filtration sub-system is at least partially disposed within the enclosure.
17. The immersion cooling system as set forth in clause 15, wherein the filtration sub-system includes at least one media filter and an ultraviolet light.
18. The immersion cooling system as set forth in clause 12, further comprising a vacuum sub-system configured to selectively maintain the tank at below an ambient pressure.
19. The immersion cooling system as set forth in clause 18, wherein the vacuum sub-system is at least partially disposed within the enclosure.
20. The immersion cooling system as set forth in clause 18, wherein the vacuum sub-system includes a condenser configured to condense at least a portion of the refrigerant and a vacuum pump configured to draw the refrigerant, in vapor form, into the condenser.

## Claims

1. An immersion cooling system comprising:
an immersion tank configured to contain a refrigerant in both liquid and vapor phases, wherein the tank is configured to contain one or more electronic devices submerged in the liquid phase of the refrigerant below a surface of the refrigerant in the tank;
a heat exchanger configured to extract heat from the refrigerant; and
a pump configured to circulate the refrigerant from the tank to the heat exchanger and back to the tank.

2. The immersion cooling system as set forth in claim 1, wherein the pump is configured to draw the refrigerant from the tank below the surface and return the refrigerant to the tank above the surface.

3. The immersion cooling system as set forth in any preceding claim, wherein the refrigerant is water-based.

4. The immersion cooling system as set forth in any preceding claim, wherein the refrigerant is water.

5. The immersion cooling system as set forth in any preceding claim, wherein the refrigerant comports with an American Society of Heating, Refrigerating and Air-Conditioning Engineers, ASHRAE, standard 34 for R718 refrigerant.

6. The immersion cooling system as set forth in any preceding claim, wherein the heat exchanger is a brazed plate heat exchanger.

7. The immersion cooling system as set forth in any preceding claim, wherein the heat exchanger is configured to transfer heat from the refrigerant to a cooling fluid.

8. The immersion cooling system as set forth in any preceding claim, further comprising an external heat exchanger disposed outside of a building housing the system, wherein the external heat exchanger is configured to reject at least a portion of the heat extracted from the one or more electronic devices into an environment outside of the building.

9. The immersion cooling system as set forth in any preceding claim, further comprising a heat recovery device disposed inside of a building housing the system, wherein the heat recovery device is configured to reject at least a portion of the heat extracted from the one or more electronic devices into a portion of the building.

10. The immersion cooling system as set forth in any preceding claim, further comprising a pump submerged in the tank below the surface and configured to accelerate the refrigerant towards the one or more electronic devices.

11. The immersion cooling system as set forth in any preceding claim, further comprising a compressor disposed within the tank above the surface and configured to compress at least a portion of the refrigerant, and optionally wherein the compressor is configured to draw in the refrigerant as saturated water vapor and to discharge the refrigerant, as water vapor at a higher pressure, to a condenser within the tank; and optionally further comprising a water deionizing sub-system configured to minimize conductivity of the refrigerant; and optionally wherein the water deionizing sub-system is at least partially disposed within the enclosure.

12. The immersion cooling system as set forth in claim 12, further comprising a filtration sub-system configured to minimize impurities within the refrigerant.

13. The immersion cooling system as set forth in claim 15, wherein the filtration sub-system is at least partially disposed within the enclosure.

14. The immersion cooling system as set forth in claim 15, wherein the filtration sub-system includes at least one media filter and an ultraviolet light.

15. The immersion cooling system as set forth in claim 12, further comprising a vacuum sub-system configured to selectively maintain the tank at below an ambient pressure; and optionally wherein the vacuum sub-system is at least partially disposed within the enclosure; and optionally wherein the vacuum sub-system includes a condenser configured to condense at least a portion of the refrigerant and a vacuum pump configured to draw the refrigerant, in vapor form, into the condenser .
